# EUROPÄISCHE PATENTSCHRIFT

(11) **EP 3 631 977 B1**
(45) Veröffentlichungstag und Bekanntmachung des Hinweises auf die Patenterteilung: **28.06.2023**
(21) Anmeldenummer: 18717896.7
(22) Anmeldetag: 11.04.2018
(51) Int. Cl.: H03F 1/02, H03F 3/183, H03F 3/217

(54) **KLASSE-D-VERSTÄRKER UND BETRIEBSVERFAHREN**
CLASS-D AMPLIFIER AND OPERATING METHOD
AMPLIFICATEUR DE CLASSE D ET PROCÉDÉ DE FONCTIONNEMENT

(30) Priorität: 30.05.2017 DE 102017209067
(43) Veröffentlichungstag der Anmeldung: 08.04.2020
(73) Patentinhaber: Robert Bosch GmbH, 70442 Stuttgart (DE)
(72) Erfinder: HOFFMEISTER, Fabian, 84337 Schoenau (DE); STEIN, Thomas, 93192 Wald (DE); SAUER, Gregor, 35510 Butzbach-Griedel (DE); ENGL, Patrick, 94372 Rattiszell (DE); PLAGER, Josef, 94327 Bogen (DE); MANDL, Markus, 94377 Steinach Agendorf (DE)
(86) Internationale Anmeldenummer: PCT/EP2018/059233
(87) Internationale Veröffentlichungsnummer: WO 2018/219537

(56) Entgegenhaltungen:
- EP-A1- 1 317 105
- EP-A1- 2 432 119
- EP-A1- 2 819 303
- EP-A2- 2 264 889
- US-A- 5 892 404
- US-A1- 2008 144 861
- US-A1- 2010 141 345
- US-A1- 2013 034 250
- US-A1- 2013 034 250
- US-A1- 2014 270 242
- US-A1- 2014 270 242
- US-A1- 2015 030 183
- US-A1- 2017 104 462

## Beschreibung

### Stand der Technik

Aus der DE 10 2012 200 524 A1 sind unter den Verstärkerarten sogenannte Klasse-D-Verstärker bekannt, welche ein analoges Signal zunächst mit einem Pulsweitenmodulator in ein pulsweitenmoduliertes Schaltsignal umwandeln, das dann verstärkt und nachfolgend über einen Filter wieder in eine sich stetig veränderliche Spannung zurückgewandelt wird. Diese Art der Verstärker sind besonders energieeffizient und werden daher bevorzugt bei Verstärkern mit hohen Leistungen eingesetzt. Vorgeschlagen wird eine Verstärkervorrichtung mit einer Steuerungseinrichtung, wobei die Steuerungseinrichtung eine Eingangsschnittstelle für ein Audiosignal aufweist, mit einer der Steuerungseinrichtung nachgeschalteten Verstärkereinrichtung zur Verstärkung des Audiosignals, wobei die Steuerungseinrichtung ein Verzögerungsmodul aufweist, wobei das Verzögerungsmodul ausgebildet ist, das Audiosignal um einen Verzögerungswert verzögert an die Verstärkereinrichtung weiterzugeben und in einer Anpassungsphase den Verzögerungswert automatisch und/oder selbsttätig von einem Startwert zu einem Endwert zu verringern.

Das Bewusstsein für Energieeinsparung hat auch die professionelle Audiotechnik erreicht.

Aus der US 2013/0034250 A1 ist ein Verstärker mit einer Versorgungsspannungssteuereinheit bekannt, um eine Leistungsversorgung mit variabler Spannung zu steuern.

Aus der US 2014/0270242 A1 ist ein Verfahren und ein Verstärker für die Verstärkung von Audiosignalen bekannt. Dabei wird entschieden, ob die Spannung einer Spannungsversorgung erhöht werden soll.

Aus der EP 2 819 303 A1 ist ein Audioverstärker bekannt, mit einem Leistungsversorgungskreis, der eine Mehrzahl von Versorgungsspannungen erzeugt, mit einer Schaltbefehlseinheit, um ein Leistungsversorgungsrelais mit einem Befehl zum Schalten der Leistungsversorgungsspannung während eines Stilleabschnitts zu versorgen, wenn eine Schaltbedingung vorliegt und ein Stilleabschnitt erkannt ist.

Aus der EP 1 317 105 A1 ist ein Verstärker bekannt, der eine Vielzahl von Versorgungskanälen mit unterschiedlichen Spannungen als Funktion von Logiksignalen verwendet. Ein digitales Signalverzögerungselement kann ein Signal verzögern, um dem Verstärker ausreichend Zeit zum Umschalten zwischen Versorgungsquellen zu geben. Ein logisches Verzögerungselement kann die Übertragung eines ersten logischen Signals durch einen Spitzendetektor verzögern, um die durch ein Filter verursachte Signalverzögerung zu kompensieren.

Aus dem Patent US 5,892,404 ist ein linearer Leistungsverstärker bekannt. Eine Leistungsquelle stellt eine vergleichsweise hohe Gleichspannung VDC1 und eine vergleichsweise niedrige Gleichspannung VDC2 zur Verfügung. Eine Spannung VCC versorgt eine Stromverstärkungsmittel. Im Betrieb steigt VCC sehr schnell an, wobei sie das Stromverstärkungsmittel mit einer höheren Spannung versorgt, die benötigt wird, um das Abschneiden des Signals ("signal clipping") zu vermeiden.

### Offenbarung der Erfindung

Im Rahmen der Erfindung wird ein Verfahren zum Betreiben eines Verstärkers der Klasse D (Klasse-D-Verstärker) mit den Merkmalen des Anspruchs 1 offenbart. Der Verstärker dient zur Verstärkung eines Audiosignals. Der Verstärker enthält einen Signalpfad für das Audiosignal, auf dem das Audiosignal durch den Verstärker geleitet und verstärkt wird. Der Verstärker enthält im Signalpfad eine Endstufe. Der Verstärker enthält im Signalpfad eine digitale Signalverarbeitungseinheit. Diese ist im Signalpfad stromaufwärts der Endstufe angeordnet.

Bei dem Verfahren wird eine Spannung zur Leistungsversorgung der Endstufe zur Verfügung gestellt. Die Spannung wird hierbei so zur Verfügung gestellt, dass diese zwei verschiedene Größen bzw. Spannungswerte (insbesondere Beträge) aufweisen kann. Im Signalpfad existiert ein Messort stromaufwärts der Signalverarbeitungseinheit. An diesem Messort wird aus dem Audiosignal ein Spannungsbedarf der Endstufe prädiktiv ermittelt, d.h. das Audiosignal am Messort bzw. derjenige Zeitabschnitt des Audiosignals, der zum Messzeitpunkt (erster Zeitpunkt) am Messort vorliegt, wird hierzu ausgewertet. Der Spannungsbedarf ist nötig für die spätere ordnungsgemäße Verstärkung des am Messort vorhandenen bzw. ausgewerteten Audiosignals in der Endstufe. Derjenige ausgewertete Signalabschnitt trifft also erst zu einem späteren, zweiten Zeitpunkt an der Endstufe ein. "Ordnungsgemäß" heißt, im Rahmen gewünschter Vorgaben störungsfrei, z.B. ohne bzw. nur mit maximal zulässigen Verzerrungen, Artefakten, Knackgeräuschen usw.

Im Verfahren wird weiterhin eine der verfügbaren Größen der Spannung gewählt. Dies geschieht, indem dem prädiktiv ermittelten Spannungsbedarf gefolgt wird. Die jeweilige Größe wird so gewählt, dass Sie für den Spannungsbedarf minimal ausreichend ist. Die Spannung der entsprechenden Größe wird an der Endstufe zu einem Zeitpunkt angelegt, der vor dem Zeitpunkt der Verstärkung des Audiosignals (zweiter Zeitpunkt) liegt, also zwischen dem ersten und zweiten Zeitpunkt. Die Signalverarbeitungseinheit weist dabei eine Laufzeit auf. Die Laufzeit ist die Zeitdifferenz zwischen dem Passieren eines Signals bzw. eines bestimmten Signalpunktes oder Signalabschnittes am Messort (erster Zeitpunkt) und der späteren Verstärkung dieses Signalabschnittes oder Signalpunktes in der Endstufe (zweiter Zeitpunkt). Bezüglich dieser Laufzeit ist die Ermittlung des Spannungsbedarfs also prädiktiv.

"Vor dem Zeitpunkt" ist so zu verstehen, dass die Spannung der entsprechend dem Spannungsbedarf benötigten Größe "rechtzeitig vorher" an der Endstufe zur Verfügung steht, bevor die Endstufe zur tatsächlichen Verstärkung des entsprechenden Signals bzw. Signalabschnitts die entsprechende Leistung aus der Spannung zum zweiten Zeitpunkt benötigt.

Gemäß der Erfindung ist gewährleistet, dass bei einem Anstieg des Leistungsbedarfs in der Endstufe rechtzeitig ausreichend hohe Spannung an der Endstufe zur artefaktfreien Verstärkung des Audiosignals zur Verfügung steht. Gleichzeitig kann mit entsprechend niedrigeren Spannungen gearbeitet werden, solange eine entsprechende Leistung nicht notwendig wird. Sobald der Spannungsbedarf wieder unter eine bestimmte Größe sinkt, wird auf die nächstniedrigere Größe zurückgeschaltet.

Mit anderen Worten wird die Endstufe also immer mit der kleinstmöglichen Spannung betrieben, solange der Spannungsbedarf die kleinste Spannung nicht übersteigt. Ansonsten wird kontinuierlich, z.B. so langsam wie möglich, auf die nächsthöhere Spannung umgeschaltet. "Kontinuierlich" bedeutet so viel wie rampenartig. Falls mehr als zwei Spannungen vorgehalten werden, wird jeweils bei Überschreitung der n-ten Größe der Spannung auf die n+1te Größe der Spannung hochgeschaltet bzw. auf die nächstniedrigere zurückgeschaltet.

Erfindungsgemäß wird die Spannung an der Endstufe mit einer maximalen Flankensteilheit von 5 Volt pro Mikrosekunde angehoben oder abgesenkt, vorzugsweise mit einer maximalen Flankensteilheit von 3 Volt pro Mikrosekunde oder 1 Volt pro Mikrosekunde oder 0,5 Volt pro Mikrosekunde oder 0,25 Volt pro Mikrosekunde oder 0,1 Volt pro Mikrosekunde zwischen den verschiedenen Größen angehoben und/oder abgesenkt. Mit anderen Worten wird die Flankensteilheit für einen Spannungsanstieg oder Spannungsabfall an der Endstufe auf entsprechende Maximalwerte begrenzt. Bei entsprechend kleiner Flankensteilheit kann so sichergestellt werden, dass der Klasse-D-Verstärker der jeweiligen Spannungsänderung seiner Versorgungsspannung artefaktfrei folgen kann, ohne zum Beispiel Verzerrungen, Störungen oder sonstige unerwünschte Effekte zu zeigen.

In einer bevorzugten Ausführungsform wird die Flankensteilheit so gewählt, dass eine Zeitdifferenz zwischen der prädiktiven Ermittlung des Spannungsbedarfes (Zeitpunkt der Analyse des Audiosignals am Messort bzw. Ermittlung des Spannungsbedarfes hieraus, erster Zeitpunkt) und dessen späterer Verstärkung in der Endstufe (zweiter Zeitpunkt) für die Änderung der Größe der Spannung gerade ausreicht. Mit anderen Worten wird somit die Spannung so langsam wie möglich ausgehend von einem aktuellen Wert zu dem Zielwert so langsam durchgeführt, dass die Spannung mit der entsprechenden Größe gemäß Spannungsbedarf gerade rechtzeitig zur Verstärkung des entsprechenden Abschnitts des Audiosignals an der Endstufe zur Verfügung steht. So kann die Flankensteilheit so weit wie möglich gesenkt werden, was die Audioeigenschaften des Klasse-D-Verstärkers weiter verbessert. Rechenzeiten zur Berechnung des Spannungsbedarfes nach Abgriff des Audiosignals am Messort werden gegebenenfalls vernachlässigt. Ansonsten wird die Änderung der Spannung ab den Zeitpunkt begonnen, zu dem der (noch immer zukünftige) Spannungsbedarf ermittelt wurde.

Gemäß der Erfindung wird für jede Größe der Spannung eine eigene bzw. separate oder individuelle Festspannung dieser Größe dauerhaft vorgehalten. Die tatsächliche Spannung wird dann über eine jeweils kontinuierliche Umschaltung zwischen den Festspannungen erzeugt. "Kontinuierlich" bedeutet, dass die Umschaltung eben nicht sprunghaft, sondern kontrolliert mit einer endlichen Flankensteilheit, insbesondere gemäß oben, erfolgt. Die Anzahl der zur Verfügung stehenden Festspannungen orientiert sich also an der Anzahl der gemäß Verfahren vorgehaltenen unterschiedlichen Größen der Spannung.

Insbesondere werden gemäß Verfahren (bipolare) Spannungen zweier unterschiedlicher Größen, zum Beispiel +/- 165 Volt und +/- 20 Volt zur Verfügung gestellt. Somit werden auch zwei Festspannungen vorgehalten, nämlich 230 Volt und 40 Volt, um die jeweils bipolaren Spannungen der festen Größen zu erzeugen.

Im Rahmen der Erfindung wird auch ein Verstärker der Klasse D gemäß Patentanspruch 4 offenbart. Der Verstärker dient zur Verstärkung eines Audiosignals. Der Verstärker enthält einen Signalpfad für die Durchleitung und Verstärkung des Audiosignals. Im Signalpfad enthält der Verstärker eine Endstufe und eine stromaufwärts der Endstufe angeordnete digitale Signalverarbeitungseinheit. Der Verstärker enthält eine Spannungsquelle zur Leistungsversorgung der Endstufe mit einer Spannung, wobei diese Spannung - wie oben erläutert - zwei verschiedene Größen aufweisen kann. Der Verstärker enthält einen im Signalpfad stromaufwärts der Signalverarbeitungseinheit angeordneten Messort.

Der Verstärker enthält eine Steuer- und Auswerteeinheit. Diese dient zur oben erläuterten prädiktiven Ermittlung eines Spannungsbedarfs aus dem Audiosignal am Messort, wobei der Spannungsbedarf der später in der Endstufe benötigten Spannungsbedarf für die spätere ordnungsgemäße Verstärkung des Audiosignals in der Endstufe ist.

Die Steuer- und Auswerteeinheit ist außerdem dazu eingerichtet, dem prädiktiv ermittelten Spannungsbedarf folgend eine jeweilige Größe der Spannung zu wählen, die für den Spannungsbedarf minimal ausreichend ist und diese vor dem Zeitpunkt der Verstärkung des Audiosignals in der Endstufe an diese anzulegen. Der Verstärker und zumindest ein Teil dessen Ausführungsformen sowie die jeweiligen Vorteile wurden sinngemäß bereits im Zusammenhang mit dem erfindungsgemäßen Verfahren erläutert.

Erfindungsgemäß enthält die Signalverarbeitungseinheit einen Digital-Analog-Konverter (digital-analog-converter, DAC). Insbesondere ist die Signalverarbeitungseinheit der Digital-Analog-Konverter. Ein entsprechender DAC weist in der Regel eine Laufzeit bzw. Latenzzeit von mehreren hundert Mikrosekunden auf. Die entsprechende Zeitverzögerung reicht bereits aus, um gemäß dem oben genannten Verfahren stromaufwärts des DAC das Audiosignal am Messort auf seinen Leistungsbedarf im Verstärker hin zu analysieren und die Spannung am Verstärker entsprechend rechtzeitig anzupassen. Außerdem lässt sich an einem Messort direkt vor dem DAC eine hochqualitative Prädiktion des Leistungsbedarfs in der Endstufe durchführen, da das Signal als solches (lediglich in digitaler statt analoger Form) bereits feststeht. Der DAC bietet im Verstärker daher einen geeigneten Bereich bzw. Ort für die Anwendung des erfindungsgemäßen Verfahrens.

In einer bevorzugten Variante dieser Ausführungsform enthält die Signalverarbeitungseinheit einen stromaufwärts des DAC angeordneten Level-Controller. Insbesondere ist die Signalverarbeitungseinheit die Kombination aus Level-Controller und nachgeschaltetem DAC. Auch ein entsprechender Level-Controller enthält nochmals eine gewisse Verzögerungszeit. Dies schafft noch mehr zeitlichen Spielraum, um eine noch langsamere Spannungsanpassung an der Endstufe durchzuführen. Dennoch lässt sich auch an einem Messort vor dem Level-Controller eine hochqualitative Prädiktion des Leistungsbedarfs durchführen.

Gemäß der Erfindung weist die Spannungsquelle einen Ausgang für die Spannung auf. Für jede Größe der Spannung weist die Spannungsquelle außerdem einen Festspannungseingang auf. Die Spannungsquelle enthält mindestens ein kontinuierlich schaltbares Schaltelement, um wahlweise verschiedene, d.h. mindestens einen, insbesondere einen einzigen der Festspannungseingänge auf den Ausgang zu schalten. Das Schaltelement kann ein einziges Bauteil, jedoch auch eine Schaltungsanordnung sein, z.B. ein Schaltelement und eine Diode.

In einer derartigen Spannungsquelle lassen sich die verschiedenen Spannungsgrößen besonders einfach bereitstellen und auch kann besonders einfach zwischen diesen kontinuierlich umgeschaltet werden, ohne Spannungssprünge zu produzieren. Durch das kontinuierlich schaltbare Schaltelement können beliebig schnelle oder langsame Rampenvorgänge - wie oben erläutert - zur Umschaltung zwischen den Spannungen verschiedener Größen erfolgen. Das Schaltelement ist insbesondere ein Feldeffekt-Transistor (FET, field-effect-transistor). Es erfolgt also eine kontinuierliche Umschaltung nach Art einer Spannungsrampe.

In einer bevorzugten Variant dieser Ausführungsform ist die Spannungsquelle eine bipolare Spannungsquelle, das heißt Sie stellt jeweils zwei Potentiale von +/-X Volt zur Verfügung. Der Ausgang und jeder Festspannungseingang weist daher jeweils zwei Pole auf. Die Spannungsquelle enthält für jeden Pol des Ausgangs mindestens ein Schaltelement. So lassen sich auch für bipolare Spannungsquellen die oben genannten Vorteile einer einfachen Bereitstellung und sprunglosen Umschaltung zwischen den Spannungen verschiedener Größen realisieren.

In einer bevorzugten Ausführungsform enthält die Spannungsquelle Pufferkondensatoren für die Spannung U lediglich auf den dem Ausgang abgewandten Seiten der Festspannungseingänge. Da die Festspannungen stets dauerhaft vorgehalten werden, sind diese Pufferkondensatoren dauerhaft geladen und werden jedenfalls nicht durch von den Schaltelementen verursachte Schaltvorgänge umgeladen. Jeder der Pufferkondensatoren ist hierbei einer jeweiligen Festspannung zugeordnet. Mit anderen Worten ist die Spannungsquelle zum Ausgang hin ohne Pufferkondensatoren ausgeführt. Bei einer Umschaltung der Spannung zwischen verschiedenen Größen müssen so keinerlei Pufferkondensatoren umgeladen werden, was zu einem besonders gleichmäßigen netzseitigen bzw. eingangsseitigen Leistungsverhalten des Verstärkers führt. Bei einer Umschaltung zwischen verschiedenen Spannungen sind somit eingangsseitig, z.B. netzseitig keine Lastsprünge am Eingang des Verstärkers zu erwarten.

In einer bevorzugten Ausführungsform des erfindungsgemäßen Verfahrens wird dieses mit Hilfe des erfindungsgemäßen Verstärkers durchgeführt.

In einer bevorzugten Ausführungsform des Verstärkers ist dieser zur Durchführung des erfindungsgemäßen Verfahrens ausgebildet.

Die Erfindung beruht auf folgenden Erkenntnissen, Beobachtungen bzw. Überlegungen und weist noch die nachfolgenden Ausführungsformen auf. Die Ausführungsformen werden dabei teils vereinfachend auch "die Erfindung" genannt. Die Ausführungsformen können hierbei auch Teile oder Kombinationen der oben genannten Ausführungsformen enthalten oder diesen entsprechen und/oder gegebenenfalls auch bisher nicht erwähnte Ausführungsformen einschließen.

Der Erfindung liegen folgende Überlegungen zu Grunde:
Bei einer professionellen Audioanlage, z.B. der Größenordnung für ein mittleres Fußballstadion, werden überschlägig bei einem üblichen Nutzungsprofil (5 Std. pro Woche Vollbetrieb, 7 × 5 Std./Woche Teilbetrieb zu 10%) über 90% der Energiekosten vom Teilbetrieb und dem Leerlaufbetrieb verursacht. Alleine der Leerlaufbetrieb der Endstufen verursacht demnach über 66% der Stromkosten. Um die Betriebskosten der Verstärker zu reduzieren, muss also insbesondere die Leistungsaufnahme im Leicht- und Leerlauffall reduziert werden. Diese Erkenntnis ist prinzipiell nicht neu. Auf dem Markt sind verschiedene Lösungen verfügbar, die den Energiebedarf in diesen Betriebsarten reduzieren. Allerdings ziehen diese Lösungen in den meisten Fällen Einschränkungen nach sich, die im Folgenden kurz aufgezeigt werden.

Das Streben nach einem möglichst hohen Wirkungsgrad eines Audioverstärkers ist so alt wie die Entwicklung von elektronischen Audioverstärkern. In den letzten Jahrzenten hat insbesondere das Aufkommen von Klasse-D Verstärkern den Wirkungsgrad von Audioverstärkern deutlich verbessert. Aber auch bei dieser Art von Verstärkern gibt es eine Vielzahl von Spielarten mit unterschiedlichen Wirkungsgraden. Diverse Kombinationen von Klasse-D mit Klasse-A/B Verstärkern werden sind mehr oder weniger erfolgversprechend. Eine gute Übersicht über den Stand der Technik bietet die Doktorarbeit "'HIGH EFFICIENCY AUDIO POWER AMPLIFIERS design and practical use', Ronan van der Zee, Universität Twente, 21.05.1999".

Wie oben erwähnt, ist in vielen Fällen gar nicht der Wirkungsgrad eines Verstärkers während des Nennbetriebs für die Energiekosten maßgeblich entscheidend, sondern vielmehr die Verlustleistung im Leerlauf- oder Leichtlaufbetrieb. Unabhängig von der Betriebsart ist allen Audioverstärkern gemein, dass die Verlustleistung im Leerlauf-/Leichtlauffall von der internen Betriebsspannung abhängt. Je höher die Betriebsspannung, desto höher die Verlustleistung. Der Zusammenhang variiert je nach Verstärkertyp zwischen linear bis quadratisch.

Aus diesem Grund ist es nach erfindungsgemäßen Überlegungen wünschenswert, die Betriebsspannung im Leerlauf- und Leichtlastfall abzusenken. Eine weitverbreitete Topologie ist im Bereich der Linearverstärker die Klasse-H Endstufe, die zwischen zwei oder mehreren gestaffelten Betriebsspannungen umschaltet. Im Leichtlastfall läuft der Verstärker auf der niedrigsten Betriebsspannung und reduziert dadurch die Leistungsaufnahme. Dieses Grundprinzip der Betriebsspannungsmodulation kann prinzipiell auf moderne Schaltverstärker (Klasse-D) übertragen. Allerdings treten hier einige prinzipbedingte Schwierigkeiten mit dadurch verbundenen Nachteilen auf:
- Im Gegensatz zu Linearverstärkern hat ein Schaltverstärker keine intrinsische Betriebsspannungsunterdrückung. Jede Veränderung der Betriebsspannung, muss durch die Gegenkopplung kompensiert werden, damit die Betriebsspannungsänderung nicht als Störung auf den Verstärkerausgang durchschlägt. Ein hartes Umschalten der Betriebsspannung führt durch die endliche Wirksamkeit der Gegenkopplung zu mehr oder weniger hörbaren Störungen im Umschaltmoment am Verstärkerausgang. Gleichzeitig führt häufig ein hartes Umschalten der Betriebsspannung aufgrund des Umladens von Puffer-Kondensatoren zu Stromstößen auf der Netzversorgung der Verstärker, was insbesondere beim gleichzeitigen Betrieb mehrerer Geräte zum Auslösen der Netzsicherung führen kann.
- Eine Lösung für dieses Problem bei Schaltverstärkern wäre ein vergleichsweise langsames Hochfahren der internen Betriebsspannung. Eine mögliche Realisierung ist ein geregeltes Netzteil. Im Leerlauffall oder Leichtlauffall stellt das Netzteil der Verstärkerstufe eine niedrige Versorgungsspannung zur Verfügung. Sobald die Ausgangsspannung ansteigt, erhöht das Netzteil die interne Betriebsspannung. In der Praxis kommt es hier zu einem nicht überwindbaren Kompromiss: Wenn das Hochfahren der Versorgungsspannung sehr langsam erfolgt, kann zwar die Gegenkopplung des Verstärkers Störungen am Ausgang auf ein akzeptables Niveau begrenzen. Gleichzeitig kann die kurzfristig erhöhte Stromaufnahme auf der Netzversorgung auf ein erträgliches Maß begrenzt werden. Der große Nachteil dieser Methode ist allerdings, dass bei plötzlicher Vollaussteuerung des Verstärkers die Versorgungsspannung nicht schnell genug hochgefahren werden kann. Die Verstärkerausgangsspannung wird dadurch für einige Zeit nicht der Verstärkereingangsspannung folgen, es kommt zwangsläufig zu nichtlinearen Verzerrungen am Verstärkerausgang, welche hörbar störend sein können. Dem kann man entgegenwirken, indem das Netzteil die Betriebsspannung schneller hochfährt, was wiederum die oben geschilderten Probleme durch die rasche Änderung der Höhe der Betriebsspannung provoziert.

Wie oben erwähnt, sind die Verluste im Niedriglast- und Leerlaufbetrieb eines Audioverstärkers im Wesentlichen von der Betriebsspannung des Leistungsteils abhängig. Die Idee der Erfindung besteht darin, die Betriebsspannung der Verstärkerblöcke abhängig vom momentanen Betriebspunkt zu wählen.
- Liegt nur ein geringer Ausgangspegel an (Hintergrundmusik, Pilotton,...) schaltet der Verstärker auf eine niedrige Versorgungsspannung (z.B. als "Low Rail" bezeichnet).
- Steigt nun der Ausgangspegel über eine gewisse Schwelle, wird ein "RAIL_UP"-Signal gesetzt und der Verstärker als Folge mit der vollen Versorgungsspannung ("High Rail") versorgt.

Je nach Anwendung und elektrischem Design kann der Umschaltvorgang der Betriebsspannung häufig oder selten erfolgen.

Eine weitere Idee der Erfindung sind folgende Punkte:
a. Beim Hochschalten der Versorgungsspannung werden keine Pufferkondensatoren umgeladen, dadurch entsteht auch kein Stromstoß auf der Netzversorgung. Das Hochschalten erfolgt dabei ausreichend langsam, so dass keine hörbaren Artefakte im Hochschaltmoment am Endstufenausgang auftreten.
b. Zeitgewinn für das Hochschalten durch Vorhersage der Ausgangsspannung: Damit Punkt a funktioniert, ist es notwendig, dass das Signal zum Hochschalten ausreichend früh erzeugt werden kann. Klassischerweise wird ein derartiges Signal durch Vergleich der Endstufenausgangsspannung mit einem Grenzwert erzeugt. Dann besteht aber genau das Problem, dass die internen Betriebsspannungen praktisch sofort hochgeschaltet werden müssen, was zu den oben erläuterten Problemen führt.

Die Erfindung geht jetzt den Weg, dass als Vergleichssignal die vorhergesagte Ausgansspannung verwendet wird.

Die vorliegende Erfindung offenbart ein neuartiges Verfahren, das den Energiebedarf von Leistungsverstärkern im Leichtlast- und Leerlauffall massiv reduziert. Dabei kommt es durch dieses Verfahren zu keinerlei Einschränkungen für die Anwendung und den Kunden im Betrieb. Da die Erfindung alleine in der Endstufe realisiert werden kann, sind auch auf Systemebene keine Vorleistungen zu treffen.

Die vorliegende Erfindung ist eine Realisierung für einen Energiesparbetrieb von Audioverstärkern im Leerlauf- und Leichtlauffall ohne Nachteile mit sich zu bringen:
- Im Leicht- und Leerlauffall werden die Verstärkerstufen auf einer niedrigeren Betriebsspannung betrieben. So wird z.B. die reguläre Betriebsspannung von +/-165V auf +/-20V im Leicht- und Leerlauffall reduziert. In diesem Beispiel reduziert sich die Verlustleistung eines Verstärkerkanals um 80%. Die Verlustleistung eines gesamten Leistungsverstärkers kann im Leerlauffall durch Einsatz der vorliegenden Erfindung mehr als halbiert werden.
- Es wird eine Lösung aufgezeigt, die beim Hochschalten der internen Versorgungsspannung keine Erhöhung der Netzstromversorgung im Hochschaltmoment verursacht.
- Es wird eine Lösung aufgezeigt, die zu keinen hörbaren Artefakten am Verstärkerausgang im Hochschaltmoment führt.
- Die Lösung arbeitet autark. Das heißt, die Energiesparfunktion wird vollautomatisch durch den Verstärker ausgeführt, weder der Kunde noch das System muss irgendwelche Vorleistungen oder Einstellungen etc. vornehmen.
- Der Verstärker ist während des Energiesparbetriebs uneingeschränkt funktionsfähig.

Die beschriebene Erfindung lässt sich in folgenden Punkten verallgemeinern:
- Das Hochfahren der Betriebsspannung kann im Falle von Mehrkanalverstärkern entweder kanalweise, für eine Gruppe von Kanälen oder für alle Kanäle gleichzeitig erfolgen.
- Die Erfindung ist am Beispiel eines Klasse-D Verstärkers mit bipolarer Versorgungsspannung beschrieben. Die Erfindung lässt sich aber auch problemlos auf Verstärkerkonzepte mit unipolaren Versorgungsspannungen übertragen.
- Die Erfindung ist aus Gründen der Anschaulichkeit am Beispiel einer Klasse-D Halbbrücke beschrieben. Die Erfindung kann auch auf Vollbrücken-Topologien übertragen werden.
- Ebenfalls aus Gründen der Anschaulichkeit wird die Erfindung am Beispiel einer geerdeten Versorgungsspannung beschrieben. Die Erfindung ist allerdings auch auf ungeerdete (floatende) Netzteilkonzepte übertragbar. Damit ist auch ein Einsatz in geerdeten Vollbrücken (Grounded Bridge) oder erdfreien Verstärkern möglich.
- Die Erfindung ist an Hand eines Verstärkers mit analogem Audioeingang gezeigt. Für die Erfindung ist es allerdings irrelevant, ob das Audiosignal analog, digital oder auf anderem Weg dem Verstärker zugeführt wird.
- Der Vergleich der errechneten Ausgangspannung (Funktionsblock "Rail-Up-Generation") kann entweder mit einer festen Schwelle erfolgen, oder die Schwelle kann dynamisch während des Betriebs verändert werden. Eine vorteilhafte Variante ist, dass die Schwelle in Abhängigkeit der tatsächlichen Spannung der niedrigen Versorgungsspannung +/- LOW RAIL nachgeführt wird. Dadurch wird erreicht, dass in der Praxis weder zu früh (erzeugt unnötige hohe Verlustleistung) noch zu spät (führt zu Verzerrungen) hochgeschaltet wird.
- Bei Verstärkern mit bipolarer Versorgungsspannung ist es auch möglich, dass immer nur die jeweils benötigte Betriebsspannungsseite hochgeschaltet wird. Es ist also möglich, zwei (positiver Zweig und negativer Zweig) Schalter nicht gleichzeitig, sondern zeitlich versetzt zu schalten.
- Die Erfindung lässt sich entweder auf eine der oben genannten Alternativen anwenden, oder auf eine beliebige Kombination der oben genannten Alternativen (z.B. geerdete Vollbrücke mit unipolarer Versorgungsspannung).

Weitere Merkmale, Wirkungen und Vorteile der Erfindung ergeben sich aus der nachfolgenden Beschreibung eines bevorzugten Ausführungsbeispiels der Erfindung sowie der beigefügten Figuren. Dabei zeigen in einer schematischen Prinzipskizze:
- Figur 1: einen Verstärker gemäß der Erfindung,
- Figur 2: die Endstufe und die Spannungsquelle aus Fig. 1 im Detail,
- Figur 3: einen Zeitverlauf von Signalen für vergleichsweise seltenes Umschalten der Spannungsgröße,
- Figur 4: einen vergleichbaren Zeitverlauf für vergleichsweise häufiges Umschalten.

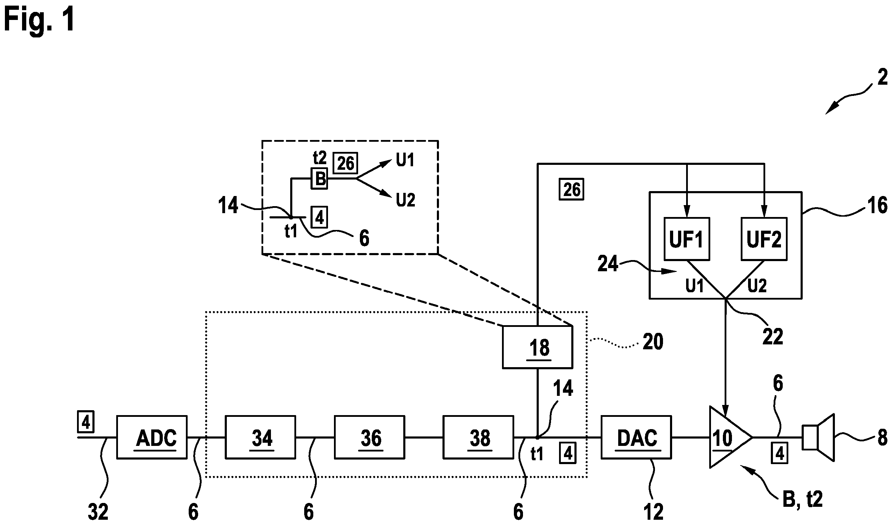

Figur 1 zeigt einen Verstärker 2 der Klasse D, also einen Klasse-D-Verstärker, zur (digitalen Verarbeitung und) Verstärkung eines Audiosignals 4. Der Verstärker 2 enthält einen Signalpfad 6, auf dem das Audiosignal 4 vom unverarbeiteten unverstärkten Zustand bis zum verstärkten bearbeiteten Zustand den Verstärker 2 durchläuft, bevor es an einem Lautsprecher 8 ausgegeben wird. Im Signalpfad 6 enthält der Verstärker 2 eine Endstufe 10, die zur eigentlichen Leistungsverstärkung des Audiosignals 4 dient. Stromaufwärts der Endstufe ist im Signalpfad 6 eine digitale Signalverarbeitungseinheit 12 angeordnet, hier ein Digital-Analog-Konverter (DAC, digital-analog-converter). Im Verstärker 2 wird eine Spannung U zur Leistungsversorgung der Endstufe 10 bereitgestellt. Die Spannung U kann hierbei zwei verschiedene Größen U1, U2 annehmen. Die Spannung U ist hierbei eine bipolare Spannung, die Größe U1 ist +/- 20 Volt und die Größe U2 ist +/- 165 Volt. Die Spannung U wird von einer Spannungsquelle 16 zur Verfügung gestellt. Die Spannungsquelle 16 dient also zur Leistungsversorgung der Endstufe 10 mit der Spannung U. Im Signalpfad 6 befindet sich ein Messort 14 stromaufwärts der digitalen Signalverarbeitungseinheit 12.

Der Verstärker 2 enthält eine Steuer- und Auswerteeinheit 18. Diese dient zur prädiktiven Ermittlung eines Spannungsbedarfs B aus dem Audiosignal 4 am Messort 14, d.h. zu demjenigen Signalabschnitt des Audiosignals, das zum Zeitpunkt t1 am Messort 14 vorhanden ist. Die Ermittlung des Spannungsbedarfs B erfolgt prädiktiv, das heißt der Spannungsbedarf B ist der später zu einem Zeitpunkt t2 in der Endstufe 10 benötigte Spannungsbedarf, das heißt die nötige Größe der Spannung U für die spätere ordnungsgemäße Verstärkung des betreffenden Signalabschnittes des Audiosignals 4 in der Endstufe 10.

Die Steuer- und Auswerteeinheit 18 ist außerdem dazu eingerichtet, dem prädiktiv ermittelten Spannungsbedarf B folgend eine jeweilige Größe U1 oder U2 der Spannung U zu wählen, die für den Spannungsbedarf B minimal ausreichend ist und diese Spannung U der entsprechenden Größe U1, 2 vor dem Zeitpunkt der Verstärkung des Audiosignals 4 an der Endstufe 10 anzulegen. Gemäß Figur 1 wird also folgendes Verfahren durchgeführt:
Das Audiosignal 4 wird im Verstärker 2 verstärkt. Die Spannung U mit den beiden Größen, U1, U2 wird bereitgestellt. Aus dem Audiosignal 4 wird am Messort 14 (zum Zeitpunkt t1) ein für dessen spätere Verstärkung (zum Zeitpunkt t2) in der Endstufe 10 benötigter Spannungsbedarf B prädiktiv ermittelt. Diesem Spannungsbedarf B folgend wird eine jeweilige Größe U1 oder U2 der Spannung U gewählt, die für den Spannungsbedarf B minimal ausreichend ist und diese Spannung U bzw. Größe U1 oder U2 vor dem Zeitpunkt der Verstärkung (t2) des Audiosignals 4 an die Endstufe 10 angelegt.

Konkret trifft also zu einem Zeitpunkt t1 ein bestimmter Abschnitt oder eine bestimmte Stelle des Audiosignals 4 am Messort 14 ein und wird dort ausgewertet. Anhand der Auswertung wird bestimmt, welchen Spannungsbedarf die Endstufe 10 zu einem Zeitpunkt t2 benötigen wird, wenn dieser Abschnitt des Audiosignals 4 an der Endstufe 10 eintrifft, um dort verstärkt zu werden. Insofern erfolgt die Ermittlung prädiktiv, da bereits zum Zeitpunkt t1 vorausgesagt wird, welcher Spannungsbedarf B die Endstufe 10 zum Zeitpunkt t2 haben wird. Es verbleibt somit die Zeitdifferenz t2-t1 (abzüglich einer eventuellen Rechenzeit zur Ermittlung des Spannungsbedarfes B), um die Spannung U auf die entsprechende Größe U1 oder U2 zu bringen.

Es gilt U1 < U2. Die Größe U1 wird daher gewählt, wenn der Spannungsbedarf B kleiner gleich der Größe U1 ist. Die Größe U2 wird gewählt, wenn der Spannungsbedarf B größer der Größe U1 ist. Der Übergang zwischen den Spannungen U1 und U2 erfolgt hierbei mit einer maximalen Flankensteilheit von einem Volt pro Mikrosekunde. Da die Zeitdifferenz t2-t1 der Verarbeitungszeit des Audiosignals 4 in der digitalen Zeitverarbeitungseinheit 12 entspricht und hier mehrere 100 Mikrosekunden beträgt, verbleibt ausreichend Zeit, um mit der gegebenen Flankensteilheit zwischen den Größen U1, 2 bei Bedarf hin und her zu wechseln bzw. umzuschalten, wobei die Umschaltung hier eben nicht sprunghaft, sondern mit der gegebenen maximalen Flankensteilheit erfolgt.

Insbesondere wird die Flankensteilheit so gewählt, dass die Zeitdifferenz t2-t1 gerade ausreicht um in der verfügbaren Zeit t2 - t1 zwischen den Größen U1 und U2 zu wechseln.

Innerhalb der Spannungsquelle 16 werden für jede der Größen U1 und U2 der Spannung U eine eigene Festspannung UF1, 2 der jeweiligen Größe U1,2 dauerhaft vorgehalten und die Spannung U über eine kontinuierliche Umschaltung zwischen den Festspannungen UF1,2 erzeugt.

Der Signalpfad 6 enthält außerdem in der Reihenfolge stromabwärts die nicht näher erläuterten Einheiten: Analog-Digital-Konverter ADC, Eingangsverarbeitung (Input-Processing) 34, Array-Steuerung (Array-Control) 36 und Lautsprecherverarbeitung ("Speaker-processing) 38. Die letzten drei genannten Komponenten zusammen mit der Steuer- und Auswerteeinheit 18, hier auch "Rail-Up-Generation" genannt, sind in einem digitalen Signalprozessor DSP 20 vereint. Die Lautsprecherverarbeitung 38 wird auch "Level-Controller" genannt bzw. kann einen solchen enthalten.

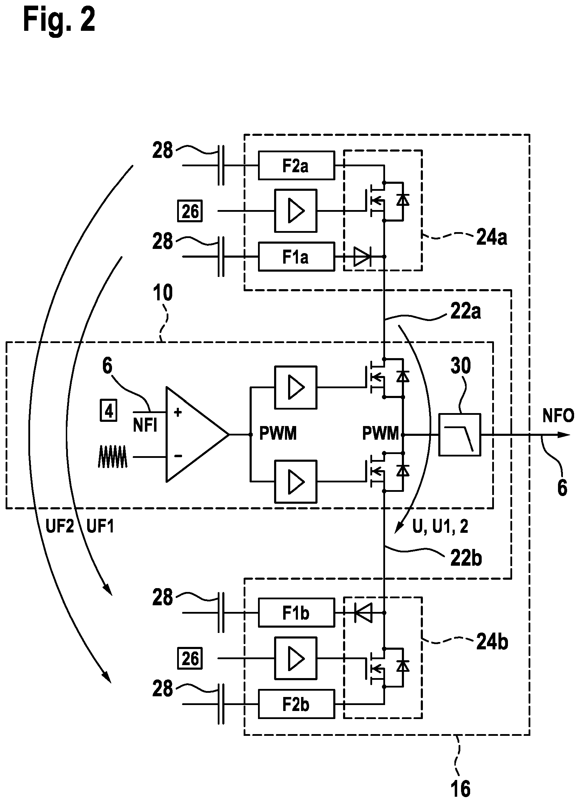

Figur 2 zeigt die Endstufe 10 sowie die Spannungsquelle 16 aus Figur 1 jeweils im Detail. Die Spannungsquelle 8 enthält einen Ausgang 22, der, da die Spannungsquelle hier bipolar ausgeführt ist, in zwei Teilausgänge 22a, b für das jeweils obere (+) und untere (-) Potential aufgeteilt ist. Die Spannungsquelle 16 ist also eine bipolare Spannungsquelle. Für jede Größe U1, U2 der Spannung weist die Spannungsquelle 18 einen Festspannungseingang F1 und F2 auf, welche hier ebenfalls aufgrund der Bipolarität als jeweils zwei Teileingänge F1a, b und F2a, b ausgeführt sind. Der Festspannungseingang F1a wird als "+ low rail" bezeichnet, F1b als "- low rail", F2a als "+ high rail" und F2b als "-high rail".

Die Spannungsquelle 16 enthält zwei kontinuierlich schaltbare Schaltelemente 24a, b welche durch ein von der Steuer- und Auswerteeinheit 18 erzeugtes Rail-Up-Signal 26 schaltbar sind.

So können wahlweise je nach Ansteuerung durch das Rail-Up-Signal 26 verschiedene Festspannungseingänge F1, 2 auf den Ausgang 22 geschaltet werden. Im Falle der Aktivierung des "High-Rail" wird dank einer Diode der Schaltelemente 26 die Spannung "Low-Rail" deaktiviert bzw. geschützt. Der Ausgang 22 und Festspannungseingänge F1, 2 weisen also jeweils die zwei genannten Pole (Schnittstelle, Anschlüsse) auf. Für jeden Pol des Ausgangs 22a, b ist ein Schaltelement 24a, b enthalten.

Der Verstärker 2 enthält hier nur symbolisch angedeutete Pufferkondensatoren 28 für die Spannung U bzw. die Festspannungen der Größen U1,2 lediglich auf den dem Ausgang 22 abgewandten Seiten der Festspannungseingänge F1,2. Da die Festspannungen stets dauerhaft vorgehalten werden, sind diese Pufferkondensatoren dauerhaft geladen und werden jedenfalls nicht durch von den Schaltelementen 24a, b verursachte Schaltvorgänge umgeladen.

Die Endstufe 10 enthält in nicht näher erläuterter und üblicher Weise einen Niederfrequenzeingang NFI und erzeugt aus diesem ein PWM-Signal PWM, welches verstärkt und über ein Tiefpassfilter 30 auf einen Niederfrequenzausgang NFO geführt wird.

Figur 2 zeigt also eine mögliche schematische Realisierungsform eines Klasse-D-Verstärkers mit schaltbaren Betriebsspannungen. Gezeigt wird hierbei eine mit einer bipolaren Versorgungsspannung (Spannung U) gespeiste Klasse-D Halbbrücke (Endstufe 10). Die Funktion des Hochschaltens der Versorgungsspannung (Spannung U von Größe U1 auf Größe U2) ohne Umladen von Pufferkondensatoren ist wie folgt:
Ein nicht dargestelltes Netzteil stellt permanent die bipolare niedrigere ("kleine") Versorgungsspannung +LOW RAIL (F1a) und - LOW RAIL (F1b) sowie die bipolare hohe (größere) Versorgungsspannung +HIGH RAIL (F2a) und -HIGH RAIL (F2b) zur Verfügung.

Im Leicht- und Leerlauffall der Endstufe 10 wird die Klasse-D Halbbrücke (bestehend aus den dargestellten, nicht näher bezeichneten Feldeffekttransistoren und dem Rekonstruktionsfilter (Tiefpassfilter 30)) über die dargestellten Dioden mit der niedrigen Versorgungsspannung U der Größe U1 versorgt.

Wenn die Endstufe 10 eine höhere Ausgangsspannung abgeben muss, d.h. der eintreffende Teil des Audiosignals 4 zu dessen ordnungsgemäßer Verstärkung einen Spannungsbedarf B der Spannung U größer der Größe U1 benötigt, werden über das Signal RAIL_UP 26 die Schaltelemente 24a,b (enthalten ebenfalls eigentlich zu schaltende Feldeffekttransistoren) durchgeschaltet. Damit wird die Klasse-D Halbbrücke mit der höheren Versorgungsspannung (Spannung U der Größe U2: + HIGH RAIL und - HIGH RAIL) versorgt.

Die Klasse-D Halbbrücke verfügt über keine lokalen Pufferkondensatoren 28, die einen nennenswerten Beitrag zur Energiespeicherung leisten. Von daher fließt im Moment des Hochschaltens der Versorgungsspannung U kein erhöhter Ladestrom. Als Folge kommt es zu keinen Stromimpulsen auf der Netzversorgung (insbesondere eingangsseitig im Netzteil) durch das Hochschalten.

Wie bereits oben ausgeführt, muss bei Klasse-D Verstärkern ein Hochfahren der Versorgungsspannung (Größe U1 auf Größe U2) vergleichsweise langsam erfolgen, damit im Hochschaltmoment es nicht zu hörbaren Artefakten am Endstufenausgang (NFO bzw. Lautsprecher 8) kommt. Diese Technik kommt hier zum Einsatz: Die Treiberstufen (FETs der Schaltelemente 24a,b) bzw. Schaltsignale (Rail-Up-Signal 26) für die Schaltelemente 24a,b sorgen für einen ausreichend langsamen Anstieg der Betriebsspannung der Versorgungsspannungen von Größe U1 auf U2, indem die Feldeffekttransistoren (in den Schaltelementen 24a,b) definiert langsam durchgeschaltet werden.

Um jetzt nicht wie oben geschildert das Problem von nichtlinearen Verzerrungen zu haben, wird folgendermaßen vorgegangen: Wie weiter unten ausgeführt werden wird, wird das RAIL-UP-Signal 26 vorausschauend bzw. prädiktiv erzeugt. Das langsame Hochfahren der Betriebsspannung (Spannung U) von der Größe U1 auf die Größe U2 wird dadurch bereits gestartet, bevor die Endstufe 10 die hohe Betriebsspannung (U2) benötigt. Durch diese Technik steht der Endstufe 10 zum richtigen Zeitpunkt t2 die hohe Spannung (U2) bereit, ohne dass es zu hörbaren Umschalt-Artefakten am Endstufenausgang (NFO) kommt.

Figur 1 zeigt die wesentlichen Funktionsblöcke des Signalflusses innerhalb eines modernen Audio-Leistungsverstärkers 2 mit digitaler Signalprocessing Funktion (DSP 20). Figur 1 zeigt damit ein Signalflussdiagramm eines Audioleistungsverstärkers mit digitaler Prozessingfunktion. Das Eingangssignal (Audiosignal 4, unverarbeitet, unverstärkt) wird dem Verstärker über den Eingang (INPUT) 32 zugeführt. Das Signal wird mittels des Analog-Digital-Konverters ADC in ein digitales Signal gewandelt. Im Funktionsblock DSP 20 erfolgen dann diverse Signalverarbeitungsvorgänge. Der Ausgang des Funktionsblocks (bzw. Ausgang der Lautsprecherverarbeitung 38 - SPEAKER PROCESSING) wird am Messort 14 abgegriffen. Der Funktionsblock RAIL_UP GENERATION (Steuer- und Auswerteinheit 18) verwendet dieses Signal und errechnet unter Berücksichtigung der Verstärkung der Endstufe 10 (CLASS-D AMP) das zu erwartende Ausgangssignal. Überschreitet das berechnete Ausgangssignal (potentielles verstärktes und bearbeitetes Audiosignal 4 am Niederfrequenzausgang NFO) eine definierte Schwelle, wird das Signal RAIL_UP 26 generiert, das wie oben beschrieben das vergleichsweise langsame Hochfahren der internen Versorgungsspannung einleitet.

Damit liegt das Signal RAIL_UP 26 bereits zu einem Zeitpunkt t1 (um Rechenzeit verzögert, s.o.) vor, bevor das Audiosignal 4 nach dem Durchlaufen des Digital-Analog-Konverters (DAC, Signalverarbeitungseinheit 12) zum Zeitpunkt t2 den eigentlichen Verstärker (Endstufe 10) erreicht. Marktübliche Digital-Analog-Konverter für Audioanwendungen haben üblicherweise Latenzzeiten von mehreren 100µs. Während das Audiosignal 4 den Digital-Analog-Konverter DAC durchläuft, wird bei Bedarf bereits parallel die Betriebsspannung von Größe U1 nach U2 hochgefahren. Die höhere Betriebsspannung der Größe U2 steht damit zum richtigen Zeitpunkt t2 (Eintreffen des am Messort 14 ausgewerteten Audiosignals 4 bzw. Signalabschnittes) dem Klasse-D Verstärker (Endstufe 10) zur Verfügung, ohne dass es zu unerwünschten Nebenwirkungen kommt.

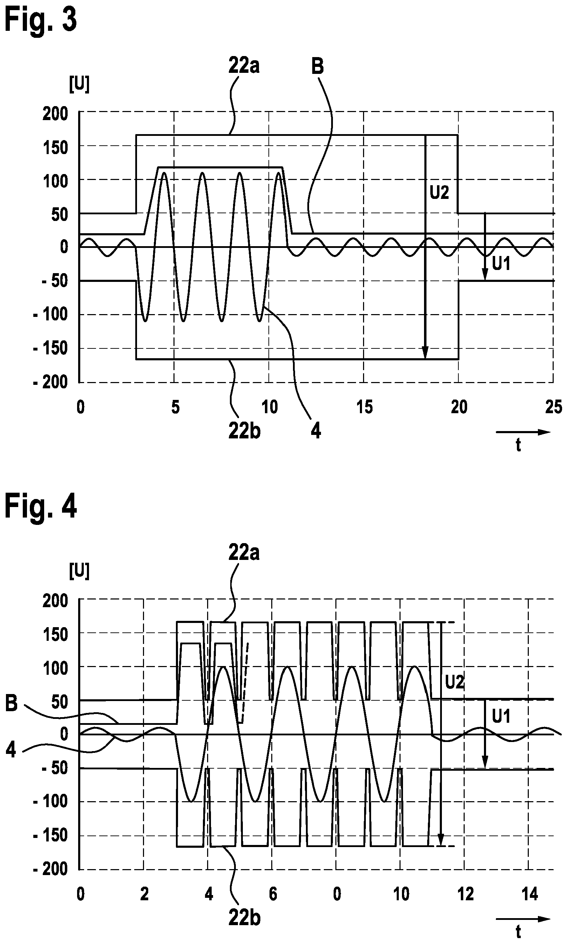

Figur 3 zeigt das Audiosignal 4 sowie den jeweilig ermittelten Spannungsbedarf B für jeden Zeitpunkt des Signals über der Zeit T Millisekunden sowie den Verlauf der Spannung U bzw. der Potentiale an den Ausgängen 22a, b bei einer vergleichsweise langsamen Schaltweise. Figur 3 zeigt eine schematische Darstellung für die Realisierung seltenen Schaltens. Aufgetragen sind lediglich zur qualitativen Erläuterung Potentiale ([U]) der Ausgänge 22a,b über der Zeit t.

Figur 4 zeigt entsprechende Vorgänge für eine schnelle Schaltweise, wobei dem entsprechenden Bedarf B jeweils sehr schnell gefolgt wird. Insgesamt ergibt sich gemäß Figur 4 eine größere Energieeinsparung als gemäß Figur 3. Figur 4 zeigt also die schematische Darstellung für die Realisierung häufigen Schaltens. Die Darstellung entspricht Figur 3

## Patentansprüche

1. Verfahren zum Betreiben eines Verstärkers (2) der Klasse D zur Verstärkung eines Audiosignals (4), wobei der Verstärker (2) in einem Signalpfad (6) für das Audiosignal (4) eine Endstufe (10) und eine stromaufwärts der Endstufe (10) angeordnete digitale Signalverarbeitungseinheit (12) enthält, wobei die Signalverarbeitungseinheit (12) einen Digital-Analog-Konverter (DAC) enthält, bei dem:
- eine Spannung (U) mit zwei verschieden Größen (U1, U2) zur Leistungsversorgung der Endstufe (10) zur Verfügung gestellt wird,
- aus dem Audiosignal (4) an einem Messort (14) im Signalpfad (6) stromaufwärts der Signalverarbeitungseinheit (12) direkt vor dem Digital-Analog-Konverter (DAC) ein für dessen spätere Verstärkung in der Endstufe (10) benötigter Spannungsbedarf (B) der Endstufe (10) prädiktiv ermittelt wird,
- dem prädiktiv ermittelten Spannungsbedarf (B) folgend eine jeweilige Größe (U1, U2) der Spannung (U) gewählt wird, die für den Spannungsbedarf (B) minimal ausreichend ist und diese vor dem Zeitpunkt (t2) der Verstärkung des Audiosignals (4) an die Endstufe (10) angelegt wird,
- für jede Größe (U1, U2) der Spannung (U) eine eigene Festspannung (UF1,2) dieser Größe (U1, U2) dauerhaft vorgehalten wird und die Spannung (U) über eine kontinuierliche und kontrollierte Umschaltung nach Art einer Spannungsrampe mit einer maximalen Flankensteilheit von 5V/ps zwischen den Festspannungen (UF1,2) derart angehoben und/oder abgesenkt wird, dass die Spannung (U) der entsprechend dem Spannungsbedarf (B) benötigten Größe rechtzeitig vorher an der Endstufe (10) zur Verfügung steht, bevor die Endstufe (10) zu einer tatsächlichen Verstärkung des entsprechenden Audiosignals (4) eine entsprechende Leistung aus der Spannung (U) zu dem Zeitpunkt (t2) benötigt.

2. Verfahren nach Anspruch 1, **dadurch gekennzeichnet, dass** die Spannung (U) an der Endstufe (10) mit einer maximalen Flankensteilheit von 3V/µs oder 1V/µs oder 0,5V/µs oder 0,25V/µs oder 0,1V/µs zwischen den verschiedenen Größen (U1, U2) angehoben und/oder abgesenkt wird.

3. Verfahren nach einem der vorhergehenden Ansprüche, **dadurch gekennzeichnet, dass** die Flankensteilheit so gewählt wird, dass eine Zeitdifferenz (t2-t1) zwischen der prädiktiven Ermittlung des Spannungsbedarfes (B) für das Audiosignal (4) und dessen späterer Verstärkung in der Endstufe (10) für die Änderung der Größe (U1, U2) der Spannung (U) gerade ausreicht.

4. Verstärker (2) der Klasse D zur Verstärkung eines Audiosignals (4), wobei der Verstärker (2) in einem Signalpfad (6) für das Audiosignal (4) eine Endstufe (10) und eine stromaufwärts der Endstufe (10) angeordnete digitale Signalverarbeitungseinheit (12) enthält, wobei die Signalverarbeitungseinheit (12) einen Digital-Analog-Konverter (DAC) enthält,
- mit einer Spannungsquelle (16) zur Leistungsversorgung der Endstufe (10) mit einer Spannung (U) mit zwei verschieden Größen (U1, U2),
- mit einem im Signalpfad (6) stromaufwärts der Signalverarbeitungseinheit (12) angeordneten Messort (14) direkt vor dem Digital-Analog-Konverter (DAC),
- mit einer Steuer- und Auswerteeinheit (18) zur prädiktiven Ermittlung eines Spannungsbedarfs (B) aus dem Audiosignal (4) am Messort (14), wobei der Spannungsbedarf (B) der später in der Endstufe (10) benötigte Spannungsbedarfs (B) für die spätere ordnungsgemäße Verstärkung des Audiosignals (4) in der Endstufe (10) ist,
- wobei die Steuer- und Auswerteeinheit (18) außerdem dazu eingerichtet ist, dem prädiktiv ermittelten Spannungsbedarf (B) folgend eine jeweilige Größe (U1, U2) der Spannung (U) zu wählen, die für den Spannungsbedarf (B) minimal ausreichend ist, und diese vor dem Zeitpunkt (t2) der Verstärkung des Audiosignals (4) in der Endstufe (10) an diese anzulegen
- die Spannungsquelle (16) einen Ausgang (22) für die Spannung (U) aufweist und für jede Größe (U1, U2) der Spannung (U) einen Festspannungseingang (F1,2) aufweist an dem eine eigene Festspannung (UF1,2) dieser Größe (U1, U2) dauerhaft vorgehalten wird, und mindestens ein kontinuierlich schaltbares Schaltelement (24a,b) enthält, um wahlweise die verschiedenen Festspannungseingänge (F1, 2) auf den Ausgang (22) derart zu schalten, dass die Spannung (U) über eine kontinuierliche und kontrollierte Umschaltung nach Art einer Spannungsrampe mit einer maximalen Flankensteilheit von 5V/µs zwischen den Festspannungen (UF1,2) derart angehoben und/oder abgesenkt wird, dass die Spannung (U) der entsprechend dem Spannungsbedarf (B) benötigten Größe rechtzeitig vorher an der Endstufe (10) zur Verfügung steht, bevor die Endstufe (10) zu einer tatsächlichen Verstärkung des entsprechenden Audiosignals (4) eine entsprechende Leistung aus der Spannung (U) zu dem Zeitpunkt (t2) benötigt.

5. Verstärker (2) nach Anspruch 4, **dadurch gekennzeichnet, dass** die Signalverarbeitungseinheit (12) einen stromaufwärts des Digital-Analog-Konverters (DAC) angeordneten Level-Controller enthält.

6. Verstärker (2) nach einem der Ansprüche 4 oder 5, **dadurch gekennzeichnet, dass** die Spannungsquelle (16) eine bipolare Spannungsquelle ist und der Ausgang (22) und jeder Festspannungseingang (F1, 2) jeweils zwei Pole (22a,b, F1a,b, F2a,b) aufweist, und die Spannungsquelle (16) für jeden Pol (22a,b) des Ausgangs (22) mindestens ein Schaltelement (24a, b) enthält.

7. Verstärker (2) nach einem der Ansprüche 4 bis 6, **dadurch gekennzeichnet, dass** die Spannungsquelle (16) Pufferkondensatoren (28) für die Spannung (U) und/oder die Festspannungen (UF1,2) lediglich auf den dem Ausgang(22) abgewandten Seiten der Festspannungseingänge (F1,2) enthält.

## Claims

1. Method for operating a class-D amplifier (2) for amplifying an audio signal (4), wherein the amplifier (2) contains, in a signal path (6) for the audio signal (4), an output stage (10) and a digital signal processing unit (12) arranged upstream of the output stage (10), wherein the signal processing unit (12) contains a digital/analogue converter (DAC), in which:
- a voltage (U) having two different levels (U1, U2) is provided for the purpose of supplying power to the output stage (10),
- a voltage requirement (B) of the output stage (10) that is needed to subsequently amplify the audio signal in the output stage (10) is predictively determined from the audio signal (4) at a measurement location (14) in the signal path (6) upstream of the signal processing unit (12) directly before the digital/analogue converter (DAC),
- in a manner following the predictively determined voltage requirement (B), a respective level (U1, U2) of the voltage (U), which is minimally sufficient for the voltage requirement (B), is selected and is applied to the output stage (10) before the time (t2) at which the audio signal (4) is amplified,
- for each level (U1, U2) of the voltage (U), a separate fixed voltage (UF1,2) of this level (U1, U2) is permanently held, and the voltage (U) is increased and/or reduced, by means of continuous and controlled switching in the form of a voltage ramp with a maximum edge steepness of 5 V/ps between the fixed voltages (UF1,2), in such a manner that the voltage (U) of the level required according to the voltage requirement (B) is available in advance in good time at the output stage (10) before the output stage (10) requires a corresponding power from the voltage (U) at the time (t2) for the purpose of actually amplifying the corresponding audio signal (4).

2. Method according to Claim 1, **characterized in that** the voltage (U) at the output stage (10) is increased and/or reduced with a maximum edge steepness of 3 V/ps or 1 V/ps or 0.5 V/ps or 0.25 V/ps or 0.1 V/ps between the different levels (U1, U2).

3. Method according to one of the preceding claims, **characterized in that** the edge steepness is selected in such a manner that a time difference (t2-t1) between the predictive determination of the voltage requirement (B) for the audio signal (4) and the subsequent amplification of the latter in the output stage (10) just suffices for the change in the level (U1, U2) of the voltage (U).

4. Class-D amplifier (2) for amplifying an audio signal (4), wherein amplifier (2) contains, in a signal path (6) for the audio signal (4), an output stage (10) and a digital signal processing unit (12) arranged upstream of the output stage (10), wherein the signal processing unit (12) contains a digital/analogue converter (DAC),
- having a voltage source (16) for supplying power to the output stage (10) with a voltage (U) having two different levels (U1, U2),
- having a measurement location (14) arranged in the signal path (6) upstream of the signal processing unit (12) directly in front of the digital/analogue converter (DAC),
- having a control and evaluation unit (18) for predictively determining a voltage requirement (B) from the audio signal (4) at the measurement location (14), wherein the voltage requirement (B) is the voltage requirement (B) subsequently required in the output stage (10) for the subsequent correct amplification of the audio signal (4) in the output stage (10),
- wherein the control and evaluation unit (18) is also configured, in a manner following the predictively determined voltage requirement (B), to select a respective level (U1, U2) of the voltage (U), which is minimally sufficient for the voltage requirement (B), and to apply it to the output stage before the time (t2) at which the audio signal (4) is amplified in the output stage (10),
- the voltage source (16) has an output (22) for the voltage (U) and has a fixed voltage input (F1,2) for each level (U1, U2) of the voltage (U), at which input a separate fixed voltage (UF1,2) of this level (U1, U2) is permanently held, and contains at least one continuously switchable switching element (24a,b) in order to selectively switch the different fixed voltage inputs (F1,2) to the output (22) in such a manner that the voltage (U) is increased and/or reduced, by means of continuous and controlled switching in the form of a voltage ramp with a maximum edge steepness of 5 V/ps between the fixed voltages (UF1,2), in such a manner that the voltage (U) of the level required according to the voltage requirement (B) is available in advance in good time at the output stage (10) before the output stage (10) requires a corresponding power from the voltage (U) at the time (t2) for the purpose of actually amplifying the corresponding audio signal (4).

5. Amplifier (2) according to Claim 4, **characterized in that** the signal processing unit (12) contains a level controller arranged upstream of the digital/analogue converter (DAC).

6. Amplifier (2) according to either of Claims 4 and 5, **characterized in that** the voltage source (16) is a bipolar voltage source, and the output (22) and each fixed voltage input (F1,2) respectively have two poles (22a,b, F1a,b, F2a,b), and the voltage source (16) contains at least one switching element (24a,b) for each pole (22a,b) of the output (22).

7. Amplifier (2) according to one of Claims 4 to 6, **characterized in that** the voltage source (16) contains buffer capacitors (28) for the voltage (U) and/or the fixed voltages (UF1,2) only on those sides of the fixed voltage inputs (F1,2) which are remote from the output (22).

## Revendications

1. Procédé permettant de faire fonctionner un amplificateur (2) de classe D pour amplifier un signal audio (4), l'amplificateur (2) comprenant sur un trajet de signal (6) pour le signal audio (4) un amplificateur de puissance (10) et une unité de traitement de signal numérique (12) disposée en amont de l'amplificateur de puissance (10), l'unité de traitement de signal (12) comprenant un convertisseur numérique/analogique (DAC), dans lequel :
- une tension (U) ayant deux grandeurs différentes (U1, U2) est fournie pour l'alimentation en puissance de l'amplificateur de puissance (10),
- au niveau d'un point de mesure (14) sur le trajet de signal (6) en amont de l'unité de traitement de signal (12), directement avant le convertisseur numérique/analogique (DAC), une demande de tension (B) de l'amplificateur de puissance (10), nécessaire à l'amplification ultérieure dudit convertisseur dans l'amplificateur de puissance (10), est déterminée de manière prédictive à partir du signal audio (4),
- selon la demande de tension (B) déterminée de manière prédictive, une grandeur respective (U1, U2) de la tension (U) est choisie qui est suffisante au minimum pour la demande de tension (B), et celle-ci est appliquée à l'amplificateur de puissance (10) avant l'instant (t2) de l'amplification du signal audio (4),
- une tension fixe propre (UF1,2) de cette grandeur (U1, U2) est tenue à disposition en permanence pour chaque grandeur (U1, U2) de la tension (U), et la tension (U) est élevée et/ou abaissée par une commutation continue et contrôlée à la manière d'une rampe de tension ayant une pente de signal maximale de 5 V/µs entre les tensions fixes (UF1,2) de telle sorte que la tension (U) de la grandeur nécessaire selon la demande de tension (B) est disponible en temps voulu au préalable au niveau de l'amplificateur de puissance (10) avant que l'amplificateur de puissance (10) ne nécessite à l'instant (t2) une puissance correspondante à partir de la tension (U) pour une amplification réelle du signal audio (4) correspondant.

2. Procédé selon la revendication 1, **caractérisé en ce que** la tension (U) est élevée et/ou abaissée au niveau de l'amplificateur de puissance (10) avec une pente de signal maximale de 3 V/µs ou 1 V/us ou 0,5 V/µs ou 0,25 V/µs ou 0,1 V/us entre les différentes grandeurs (U1, U2).

3. Procédé selon l'une quelconque des revendications précédentes, **caractérisé en ce que** la pente de signal est choisie de telle sorte qu'une différence de temps (t2-t1) entre la détermination prédictive de la demande de tension (B) pour le signal audio (4) et son amplification ultérieure au niveau de l'amplificateur de puissance (10) est juste suffisante pour la modification de la grandeur (U1, U2) de la tension (U).

4. Amplificateur (2) de classe D permettant d'amplifier un signal audio (4), l'amplificateur (2) comprenant sur un trajet de signal (6) pour le signal audio (4) un amplificateur de puissance (10) et une unité de traitement de signal numérique (12) disposée en amont de l'amplificateur de puissance (10), l'unité de traitement de signal (12) comprenant un convertisseur numérique/analogique (DAC), comprenant
- une source de tension (16) pour l'alimentation en puissance de l'amplificateur de puissance (10) avec une tension (U) ayant deux grandeurs différentes (U1, U2),
- un point de mesure (14) disposé sur le trajet de signal (6) en amont de l'unité de traitement de signal (12), directement avant le convertisseur numérique/analogique (DAC),
- une unité de commande et d'évaluation (18) pour la détermination prédictive d'une demande de tension (B) à partir du signal audio (4) au point de mesure (14), la demande de tension (B) étant la demande de tension (B) nécessaire ultérieurement au niveau de l'amplificateur de puissance (10) pour l'amplification correcte ultérieure du signal audio (4) au niveau de l'amplificateur de puissance (10),
- dans lequel l'unité de commande et d'évaluation (18) est en outre aménagée pour choisir selon la demande de tension (B) déterminée de manière prédictive une grandeur respective (U1, U2) de la tension (U) qui est suffisante au minimum pour la demande de tension (B), et pour l'appliquer à l'amplificateur de puissance (10) avant l'instant (t2) de l'amplification du signal audio (4) au niveau de l'amplificateur de puissance (10),
- la source de tension (16) présente une sortie (22) pour la tension (U) et une entrée de tension fixe (F1,2) pour chaque grandeur (U1, U2) de la tension (U) à laquelle une tension fixe propre (UF1,2) de cette grandeur (U1, U2) est fournie en permanence, et comprend au moins un élément de commutation (24a,b) pouvant être commuté en continu afin de commuter au choix les différentes entrées de tension fixe (F1,2) sur la sortie (22) de telle sorte que la tension (U) est élevée et/ou abaissée par une commutation continue et contrôlée à la manière d'une rampe de tension ayant une pente de signal maximale de 5 V/µs entre les tensions fixes (UF1,2) de telle sorte que la tension (U) de la grandeur nécessaire selon la demande de tension (B) est disponible en temps voulu préalablement au niveau de l'amplificateur de puissance (10) avant que l'amplificateur de puissance (10) ne nécessite à l'instant (t2) une puissance correspondante à partir de la tension (U) pour une amplification réelle du signal audio (4) correspondant.

5. Amplificateur (2) selon la revendication 4, **caractérisé en ce que** l'unité de traitement de signal (12) comprend un contrôleur de niveau disposé en amont du convertisseur numérique/analogique (DAC).

6. Amplificateur (2) selon l'une quelconque des revendications 4 ou 5, **caractérisé en ce que** la source de tension (16) est une source de tension bipolaire et la sortie (22) et chaque entrée de tension fixe (F1,2) présente respectivement deux pôles (22a,b, F1a,b, F2a,b), et la source de tension (16) comprend pour chaque pôle (22a,b) de la sortie (22) au moins un élément de commutation (24a,b).

7. Amplificateur (2) selon l'une quelconque des revendications 4 à 6, **caractérisé en ce que** la source de tension (16) comprend des condensateurs tampons (28) pour la tension (U) et/ou les tensions fixes (UF1,2) uniquement sur les côtés des entrées de tension fixe (F1,2) détournés de la sortie (22).
